# EUROPEAN PATENT APPLICATION

(11) **EP 1 944 552 A2**
(43) Date of publication of application: **16.07.2008**
(21) Application number: 07124160.8
(22) Date of filing: 28.12.2007
(51) Int. Cl.: F24C 3/12, F24C 7/08

(54) **Cook top control pad and alphanumeric displays integrated therewith**

(30) Priority: 03.01.2007 IT BO20070001
(71) Applicant: SELTA S.r.l., 40050 Calderino Di Monte S. Pietro BO (IT)
(72) Inventor: Biolcati, Gian Pietro, 40050, Calderino di Montes S. Pietro (BO) (IT)
(74) Representative: Dall'Olio, Giancarlo

(57) **Abstract**

A cook top control pad includes: a capacitive keypad (4-1), set in contact with a cook top (1) and electrically connected to a control unit (C), so that the latter detects positioning of at least one finger of a user in selected areas of the upper surface of the same cook top (1); and a through hole (4-2), aimed at being associated to a display (4-3), electrically connected to the control unit (C); and means (4-4) of electric connection of the display (4-3) to tracks made on a control pad (4) near the edges of the through hole (4-2), for the electric connection of the display (4-3) with the control unit (C). Said electric connection means (4-4) can also mechanically fasten the display (4-3) to the control pad (4), and can be provided on the upper side, lateral portion as well as lower side of the display base (4-3-1).

## Description

The present invention relates to electronic pads applied to tops for cooking food, e.g. for electric applications, in particular including capacitive technology keypads and alphanumeric displays.

Currently, there are electronic pads that implement the so-called "touch control" technology, since they are capable of distinguishing between the touch of a finger and of any other thing on selected cook top portions, delimited by marks or squares representing for example related push-buttons. This is obtained by sophisticated calculation algorithms and comes into effect, for example, when a user imparts a command for regulation of the power of the electric burners situated below the same cook top. In particular, such distinguishing capability can be set into effect by the capacitive keypads, since the contact of the user's finger with a related square establishes a ground connection, which is followed by a variation of the capacity of the so defined equivalent circuit, having armatures constituted by the corresponding "pushbutton" of the keypad situated below the square and by the user's finger, while the dielectric is defined by the layer of material of the cook top interposed therebetween.

The cook top is smooth, usually made of glass ceramic, and it has, in its upper part and within a delimited lateral region, a plurality of marks, for example rectangular, substituting traditional push-buttons. The electronic pad is situated below the top of glass ceramic and includes, substantially: a capacitive keypad, set in direct contact with the cook top in a position corresponding to the above mentioned marks, connected electrically to a processing and control unit of the power unit that supplies the electric burners; and a series of alphanumeric displays, associated to the keypad for the operation of the electric burners (turning on and off, regulation) by the user.

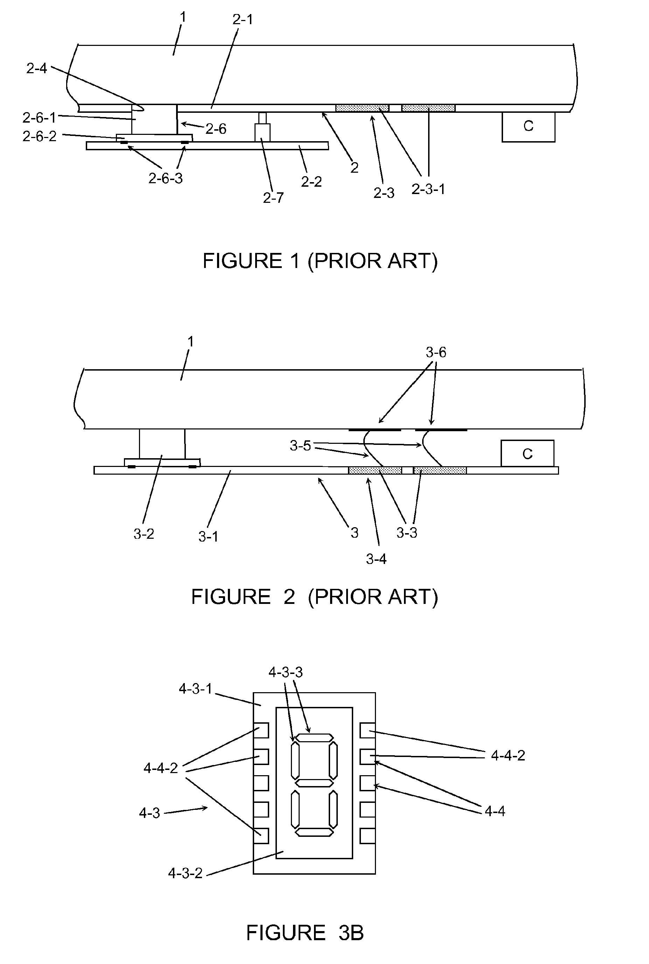

A first constructive solution, known to those skilled in the art, has been shown schematically in Fig. 1, in which the reference numeral 1 indicates the cook top made of glass ceramic and 2 indicates the electronic pad, in this case including two electronic boards 2-1, 2-2, in which: the first 2-1, set in contact with the cook top 1, includes a capacitive keypad 2-3, having a plurality of conductor elements or "push-buttons" 2-3-1, a plurality of N suitable through holes 2-4 and a control unit C; and the second 2-2, situated below, carries a corresponding plurality of N alphanumeric displays 2-6, aimed at being partially inserted through the associated through holes 2-4, and is electrically connected to the first board 2-1 by means of a related connector 2-7.

Each display 2-6 is formed by a body 2-6-1, aimed at being partially inserted in a corresponding through hole 2-4, to allow the user seeing related LED or light segments provided on the upper side thereof, and a lower base 2-6-2, protruding laterally with respect to said body 2-6-1, that carries, on its lower side, respective pins (PTH-technology) o conductive marks (SMD technology) 2-6-3 (only sketched in Fig.1) for electrical connection of the display 2-6 with the printed circuit of the second board 2-2.

The second electronic board 2-2 is provided for supporting the displays 2-6, and the distance between the second board and the first board 2-1 is strictly connected to the dimensional space occupied by the same displays 2-6, taking in consideration the need to insert the upper portion of the body 2-6-1 of the latter through the corresponding holes 2-4, so as to allow the user to have the optimal sight of the related LED.

A second known construction solution has been shown in Fig. 2 and differs from the first one by the fact that it includes an electronic pad 3, formed by only one board 3-1, that supports also the displays 3-2; for this purpose, the board 3-1 is placed at a suitable distance from the cook top 1 made of glass ceramic and the conductor elements or "push-buttons" 3-3 of the capacitive keypad 3-4 are associated to the marks or squares, depicted on the surface of glass ceramic 1, by electric connections 3-5 with corresponding thin metallic plates 3-6 set in contact with the lower surface of the same glass ceramic 1.

The drawbacks of the known solutions, described above, derive substantially from their high production cost and excessive size, at this point unsuitable for the market expectations, turned toward more and more compact solutions.

In the light of what said above, the object of the present invention is to propose a control pad for cook tops, that is newly conceived, has reduced dimensions with respect to the known solutions and lower production costs with respect to the advantages to be pursued.

Another object of the present invention is to propose a newly worked out display, which is to be electrically connected, in an easy way, to a printed electronic board or the like, situated above it; such display is herein proposed with the aim to advantageously integrate it into the control pad for cook tops, likewise proposed by the present invention.

The above mentioned objects are obtained in accordance with the contents of the claims, by proposing a control pad that includes: a capacitive keypad having its upper side set in contact, with a cook top of semi-transparent type, and electrically connected to a control unit, so that the latter detects the position of at least one finger of a user in selected areas of the upper surface of the same cook top; at least one through hole, aimed at receiving therein a corresponding alphanumeric display, likewise electrically connected to the control unit; and means for electric connection of the display to suitable tracks, provided on the same control pad near its opening edges, for the electric connection of the display with the control unit.

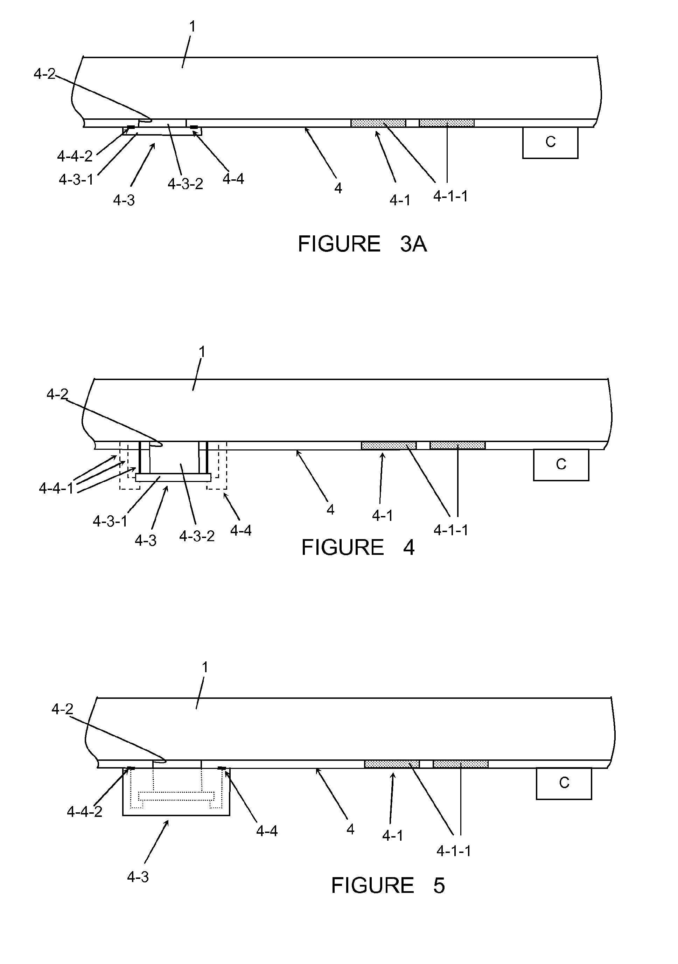

Advantageously, a similar electronic pad (Figs. 3A, 4, 5) includes only one electronic board, set to adhere strictly to the cook top made of glass ceramic, so that the related displays inserted into the relevant through holes of the same board are advantageously connected directly to the board; the result is a substantial reduction of the control pad dimensions, a reduction of the quantity of materials and of the used components, and consequently also of the production costs with respect to the prior art.

In addition, a new typology of alphanumeric displays is defined, including: a body, provided in its upper part with elements of visual lighting (LED); and a lower base, protruding sidewise from the body and carrying respective terminal conductive portions of electric connection, accessible from a level equal or higher than the upper side of the same base. Such terminal conductive portions are formed by respective pins (PTH technology) or conductive marks (SMD technology) and their arrangement, according to the invention, facilitates the assembly of the related display of the control pad proposed by the invention.

The so obtained display is new, original and facilitates the related electric connection with electric circuits, situated thereabove, such as electronic boards.

The characteristic features of the invention, not appearing from what has been just said, will be better pointed out in the following description, in accordance with the contents of the claims and with help of the enclosed figures, in which:
Figs. 1, 2 are corresponding schematic, lateral views of control pads associated to the cook tops, according to as many constructive solutions, known to those skilled in the art;
Figs. 3A, 4, 5 show respective schematic and partial, lateral views of the control pad proposed by the present invention, with associated thereto alphanumeric displays in as many embodiments;
Fig. 3B shows separately a top view of an alphanumeric display of Fig. 3A, likewise proposed by the invention.

With reference to Figs. 3A, 3B, 4, 5, the reference numeral 1 indicates a transparent or semi-transparent cook top, for example made of glass ceramic, and 4 indicates an electronic pad, fastened to a frame, not shown and including: a capacitive keypad 4-1 of known type, provided with a plurality of conductor elements or "push-buttons" 4-1-1; a plurality of K through holes 4-2; a plurality of K alphanumeric displays 4-3, shown according to as many variants in Figs. 3A, 4, 5, aimed at being inserted within through holes 4-2, so as to be seen in optimal way by the user (as specified in the introductory note), and at being connected directly to the tracks of the printed circuit, made in the pad 4, not shown in the figures; and a control unit C, electrically connected to the keypad 4-1, to the plurality of displays 4-3, and to a power unit (not shown, as known), so as to power the electric burners (likewise not shown), associated to the cook top 1, by said tracks of the printed circuit made in the control pad 4.

The means 4-4 for electric connection of each display 4-3 with the track of the printed circuit of the control pad 4 are substantially formed: by feet 4-4-1, having suitable conformation and dimensions, of the preformed type, so as to be welded to the lower surface of the pad 4 and according to known techniques (PTH technology), see Fig. 4; by conductive marks 4-4-2 (SMD technology), advantageously provided on the upper side of the base 4-3-1 of the display 4-3, as it will be better specified later, and aimed at being welded to the same tracks, see Figs. 3A, 3B and 5.

Such electric connection between the displays 4-3 and the tracks of the printed circuit of the control pad 4 is ensured, for example, by welding, as it has been said; this ensures also mechanical fastening of the displays 4-3 to the same pad 4.

The alphanumeric displays 4-3 have been shown in Figs. 3A, 3B, 4, 5 according to distinct embodiments, that will be described in the following.

With reference to Figs. 3A, 3B, each display 4-3 includes: a body 4-3-2, aimed at being inserted freely in the corresponding through hole 4-2, so as to allow displaying, through the surface of glass ceramic 1, of the related LED 4-3-3, provided on the upper side thereof; and a lower base 4-3-1, protruding laterally from the body 4-3-2, that advantageously carries, on its upper side, the conductive marks 4-4-2 for the electric connection of the display 4-3 with the electric tracks of the pad 4. The height of the body 4-3-2 is substantially equal to the depth of the through hole 4-2, inside which the same body 4-3-2 must be inserted: this determines the direct contact or the brushing of the conductive marks 4-4-2 with the tracks of the control pad 4, so that their stable electric connection can be ensured with a simple welding operation.

With reference to Fig. 4, the body 4-3-2 of each display 4-3 can have dimensions generally bigger of the through hole 4-2 depth, and thus it is inserted therein only partially; the means of electric connection 4-4 of the display 4-3 with the tracks of the control pad 4 include, as already said, preformed wire leads or pins 4-4-1, extending for example, from the upper side of the related base 4-3-1, and having length that makes them suitable to be welded to the lower surface of the control pad 4 in positions corresponding to the tracks. Such wire leads or pins 4-4-1 can originate also from the lateral walls or from the lower face of the base 4-3-1 (see broken lines in Fig. 4); in this case, their dimensions and conformation will make them suitable to be operationally connected by welding to the tracks of the control pad 4.

Otherwise, the known technology SMD can possibly be used, even without the display 4-3 having the body 4-3-2 of the height equal to the through hole 4-2 depth; this can be obtained by a display 4-3 of the type shown in Fig. 4, drowning the base 4-3-1, a suitable part of the body 4-3-2 of the terminals or pins 4-4-1 in a plastic material, so as to obtain a new display 4-3, functionally analogous to the one shown in Figs. 3A, 3B (see Fig. 5).

## Claims

1. Cook top control pad, associated to a frame, including:
a capacitive keypad (4-1), having its upper side set in contact with an at least partially transparent cook top (1), electrically connected to a control unit (C), so that the latter detects positioning of at least one finger of a user in selected areas of the upper surface of the same cook top (1); and
at least one opening (4-2), aimed at being associated to at least one display (4-3) for visualization of information, the display being likewise electrically connected to said control unit (C),
the cook top control pad being **characterized in that** it also includes means (4-4) for electric connection of said display (4-3) to suitable tracks provided on the same control pad (4) near the edges of said opening (4-2), for electric connection of said display (4-3) with said control unit (C).

2. Control pad, according to claim 1, **characterized in that** said display (4-3) is also mechanically fastened to said control pad (4) by the same electric connection means (4-4).

3. Control pad, according to claim 1, **characterized in that** said electric connection (4-4) include corresponding wire leads or pins or terminals (4-4-1) of said display (4-3), whose configuration and/or dimensioning makes them suitable for being electrically connected to said tracks of said control pad (4).

4. Control pad, according to claim 3, with said display (4-3) including a body (4-3-2), aimed at being inserted, at least partially through said opening (4-2) to allow visualization of its light elements, and a lower base (4-3-1) protruding sidewise with respect to the body and carrying said wire leads or pins or terminals (4-4-1), **characterized in that** said wire leads or pins or terminals (4-4-1) are provided on the upper part of said base (4-3-1) and their conformation and/or dimensioning make them suitable for being electrically connected to the above tracks of said control pad (4).

5. Control pad, according to claim 1, with said display (4-3) including a body (4-3-2), aimed at being inserted, at least partially through said opening (4-2) to allow visualization of its light elements (4-3-3), and a lower base (4-3-1), protruding sidewise with respect to the body that carries respective conductive marks (4-4-2), **characterized in that** said conductive marks (4-4-2) are provided on the upper part of said base (4-3-1) and are aimed at being electrically connected to the above tracks of said control pad (4).

6. Alphanumeric display, of the type including: a body (4-3-2), provided, in its upper part, with elements of visual lighting; and a lower base (4-3-1), protruding sidewise from said body (4-3-2) and carrying respective terminal conductive portions (4-4) of electric connection, **characterized in that** said terminal conductive portions (4-4) are accessible from a level equal or higher than the upper side of said base (4-3-1).

7. Alphanumeric display, according to claim 6, **characterized in that** said terminal conductive portions (4-4) include corresponding conductive marks (4-4-2), made on the upper side of said base (4-3-1).

8. Alphanumeric display, according to claim 6, **characterized in that** said terminal conductive portions (4-4) include corresponding wire leads or pins (4-4-1), that extend from said upper side of said base (4-3-1).

9. Alphanumeric display, according to claim 6, **characterized in that** said terminal conductive portions (4-4) include corresponding wire leads or pins (4-4-1), that extend from the lateral portions of said base (4-3-1).

10. Alphanumeric display, according to claim 6, **characterized in that** said terminal conductive portions (4-4) include corresponding feet (4-4-1), that extend from said lower side of said base (4-3-1).
